# EUROPEAN PATENT SPECIFICATION

(11) **EP 4 096 091 B1**
(45) Date of publication and mention of the grant of the patent: **21.10.2026**
(21) Application number: 21176438.6
(22) Date of filing: 28.05.2021
(51) Int. Cl.: H03F 3/45, H03F 1/42

(54) **DIFFERENTIAL AMPLIFIER AND METHOD FOR ACHIEVING MAXIMUM ACHIEVABLE GAIN OF A DIFFERENTIAL AMPLIFIER**
DIFFERENZVERSTÄRKER UND VERFAHREN ZUR ERZIELUNG EINER MAXIMAL ERREICHBAREN VERSTÄRKUNG EINES DIFFERENZVERSTÄRKERS
AMPLIFICATEUR DIFFÉRENTIEL ET PROCÉDÉ PERMETTANT D'OBTENIR UN GAIN RÉALISABLE MAXIMAL D'UN AMPLIFICATEUR DIFFÉRENTIEL

(43) Date of publication of application: 30.11.2022
(73) Proprietor: Imec VZW, 3001 Leuven (BE); Vrije Universiteit Brussel, 1050 Brussel (BE)
(72) Inventor: Park, Sehoon, 3001 Leuven (BE); Park, Daewoong, 3001 Leuven (BE); Wambacq, Pierre, 3001 Leuven (BE); Craninckx, Jan, 3001 Leuven (BE)
(74) Representative: Roth, Sebastian

(56) References cited:
- CN-A- 111 211 745
- US-A1- 2013 321 080
- US-A1- 2021 135 637
- SHAFIULLAH YASIR ET AL: "A Voltage Controlled Oscillator with Inductive Divider Design and Analysis at Frequencies Above 100 GHz", 2020 IEEE NORDIC CIRCUITS AND SYSTEMS CONFERENCE (NORCAS), IEEE, 27 October 2020 (2020-10-27), pages 1 - 5, XP033864326, DOI: 10.1109/NORCAS51424.2020.9265130
- PARK DAE-WOONG ET AL: "A 230-260-GHz Wideband and High-Gain Amplifier in 65-nm CMOS Based on Dual-Peak $G_{{\mathrm{max}}}$ -Core", IEEE JOURNAL OF SOLID-STATE CIRCUITS, IEEE, USA, vol. 54, no. 6, 1 June 2019 (2019-06-01), pages 1613 - 1623, XP011726796, ISSN: 0018-9200, [retrieved on 20190523], DOI: 10.1109/JSSC.2019.2899515

## Description

The invention relates to a differential amplifier, especially a differential amplifier achieving maximum achievable gain, and a method for achieving maximum achievable gain of a differential amplifier.

Generally, in times of an increasing number of communication applications employing high frequencies over a broad bandwidth, there is a growing need of a differential amplifier, especially for ultra-broad band without gain drop, and a method for achieving maximum achievable gain of a differential amplifier in order to satisfy the requirements of such communication applications.

CN 111211745 A discloses to a power amplifier comprising a differential common-source amplifier and two LC resonance circuits connected to the gate and drain ends of the differential common-source amplifier in a crossed mode. In accordance with said power amplifier, a double-peak Gₘₐₓ curve is obtained through the resonance circuit and the equivalent neutralization capacitance effect of the resonance circuit at high frequency, the bandwidth of the amplifier is expanded, and the high-frequency gain is improved. However, due to the foregoing configuration, especially said LC resonance circuits, the maximum achievable gain can disadvantageously not be achieved over an ultra-broad band without gain drop. HAFIULLAHYASIR ET AL: "A Voltage Controlled Oscillator with Inductive Divider Design and Analysis at Frequencies Above 100 GHz",DOI: 10.1109/ NORCAS51424.2020.9265130, discloses a low-power millimeter-wave LC VCO above 100 GHz using inductors in the cross-coupled pair to improve negative resistance and efficiency. 1

Accordingly, there is an object to provide a differential amplifier, especially a differential amplifier achieving maximum achievable gain preferably over an ultra-broad band, and a method for achieving maximum achievable gain of a differential amplifier, especially a method for achieving maximum achievable gain of a differential amplifier over an ultra-broad band, thereby ensuring a particularly high accuracy and efficiency of amplification.

This object is solved by the features of the first independent claim for a differential amplifier and the features of the second independent claim for a method for achieving maximum achievable gain of a differential amplifier. The dependent claims contain further developments.

According to a first aspect of the invention, a differential amplifier is provided. Said differential amplifier comprises a first single-ended amplifying means comprising at least a first terminal and a second terminal, a second single-ended amplifying means comprising at least a first terminal and a second terminal, a first transmission line, and a second transmission line. In this context, the first terminal of the first single-ended amplifying means is connected to the second terminal of the second single-ended amplifying means via the first transmission line. In addition to this, the first terminal of the second single-ended amplifying means is connected to the second terminal of the first single-ended amplifying means via the second transmission line.

Advantageously, the maximum achievable gain is achieved especially without gain drop over an ultra-broad frequency band, which, allows for amplifying in a particularly accurate and efficient manner.

It is noted that the corresponding algebraic sign of amplification with respect to the first single-ended amplifying means or the second single-ended amplifying means, respectively, may especially be negative.

It is further noted that it might be particularly advantageous if the first terminal of the first single-ended amplifying means is an input and/or the second terminal of the first single-ended amplifying means is an output. Analogously, the first terminal of the second single-ended amplifying means may preferably be an input and/or the second terminal of the second single-ended amplifying means may preferably be an output.

According to a first preferred implementation form of the first aspect of the invention, the differential amplifier further comprises a first capacitance, especially a first capacitor, wherein said first capacitance, especially said first capacitor, is inserted between the first terminal of the first single-ended amplifying means and the first transmission line in a serial manner or between the first transmission line and the second terminal of the second single-ended amplifying means in a serial manner.

In addition to this, the differential amplifier further comprises a second capacitance, especially a second capacitor, wherein said second capacitance, especially said second capacitor, is inserted between the first terminal of the second single-ended amplifying means and the second transmission line in a serial manner or between the second transmission line and the second terminal of the first single-ended amplifying means in a serial manner.

Advantageously, for example, efficiency of amplification can further be increased.

According to a further preferred implementation form of the first aspect of the invention, the value of the first capacitance is between 50 femtofarad and 200 femtofarad, preferably between 100 femtofarad and 150 femtofarad, per millimeter of the length of the first transmission line. In addition to this or as an alternative, the value of the second capacitance can be between 50 femtofarad and 200 femtofarad, preferably between 100 femtofarad and 150 femtofarad, per millimeter of the length of the second transmission line. Advantageously, for instance, design simplicity can be increased, thereby reducing inefficiencies.

According to a second preferred implementation form of the first aspect of the invention, the length of the first transmission line is between a twentieth and a quarter, preferably between a fifteenth and a sixth, of the respective signal wavelength. In addition to this or as an alternative, the length of the second transmission line is between a twentieth and a quarter, preferably between a fifteenth and a sixth, of the respective signal wavelength. Advantageously, for example, complexity can be reduced, which leads to an increased efficiency.

According to a further preferred implementation form of the first aspect of the invention, the length of the first transmission line is at least 50 micrometers, preferably at least 100 micrometers. Additionally or alternatively, the length of the second transmission line is at least 50 micrometers, preferably at least 100 micrometers. Advantageously, for instance, implementing the inventive amplifier can be achieved in a simple, and thus cost-efficient, manner.

According to the first aspect of the invention, the value of the first capacitance is between one and three times, preferably between 1.5 and 2.5 times, the value of the respective first-terminal-to-second-terminal capacitance of the first single-ended amplifying means. In addition to this or as an alternative, the value of the second capacitance is between one and three times, preferably between 1.5 and 2.5 times, the value of the respective first-terminal-to-second-terminal capacitance of the second single-ended amplifying means. Advantageously, for example, design complexity can further be reduced, which leads to an increased efficiency. It is noted that at least one, preferably each, of the respective first-terminal-to-second-terminal capacitance of the first single-ended amplifying means and the respective first-terminal-to-second-terminal capacitance of the second single-ended amplifying means may be a parasitic capacitance.

According to a further preferred implementation form of the first aspect of the invention, wherein the differential amplifier further comprises a first passive element network, wherein said first passive element network is inserted between the first terminal of the first single-ended amplifying means and the first transmission line in a serial manner or, in the case that the first capacitance is present, between the first terminal of the first single-ended amplifying means and the first capacitance in a serial manner.

In addition to this or as an alternative, the differential amplifier further comprises a second passive element network, wherein said second passive element network is inserted between the first terminal of the second single-ended amplifying means and the second transmission line in a serial manner or, in the case that the second capacitance is present, between the first terminal of the second single-ended amplifying means and the second capacitance in a serial manner.

According to a further preferred implementation form of the first aspect of the invention, the first passive network comprises or is a first inductance, especially a first inductor. Additionally or alternatively, the second passive network comprises or is a second inductance, especially a second inductor. Advantageously, for example, complexity can further be reduced, which leads to an increased efficiency.

According to a further preferred implementation form of the first aspect of the invention, the differential amplifier further comprises a third passive element network, wherein said third passive element network is inserted between the second terminal of the first single-ended amplifying means and the second transmission line in a serial manner or, in the case that a capacitance, especially the above-mentioned second capacitance, is present, between the second terminal of the first single-ended amplifying means and the second capacitance in a serial manner.

In addition to this or as an alternative, the differential amplifier further comprises a fourth passive element network, wherein said fourth passive element network is inserted between the second terminal of the second single-ended amplifying means and the first transmission line in a serial manner or, in the case that a capacitance, especially the above-mentioned first capacitance, is present, between the second terminal of the second single-ended amplifying means and the first capacitance in a serial manner.

According to a further preferred implementation form of the first aspect of the invention, the third passive network comprises or is a third inductance, especially a third inductor. Additionally or alternatively, the fourth passive network comprises or is a fourth inductance, especially a fourth inductor. Advantageously, for example, design complexity can further be reduced, which leads to an increased efficiency.

According to a further preferred implementation form of the first aspect of the invention, the first single-ended amplifying means comprises or is a first transistor, wherein the first terminal of the first single-ended amplifying means is connected or equal to a gate terminal of said first transistor and the second terminal of the first single-ended amplifying means is connected or equal to a drain terminal of said first transistor.

In addition to this or as an alternative, the second single-ended amplifying means comprises or is a second transistor, wherein the first terminal of the second single-ended amplifying means is connected or equal to a gate terminal of said second transistor and the second terminal of the second single-ended amplifying means is connected or equal to a drain terminal of said second transistor.

Advantageously, for instance, simplicity can further be increased, which leads to reduced inefficiencies.

Before the second aspect of the invention and its preferred implementation forms are described in the following, it is noted that all the advantages mentioned above analogously apply for the inventive method explained below. It is further noted that specific values and/or configurations with respect to the first aspect of the invention analogously and preferably apply for the second aspect.

According to a second aspect of the invention, a method for achieving maximum achievable gain of a differential amplifier is provided. Said method comprises the steps of providing a first single-ended amplifying means comprising at least a first terminal and a second terminal, a second single-ended amplifying means comprising at least a first terminal and a second terminal, a first transmission line, and a second transmission line, connecting the first terminal of the first single-ended amplifying means to the second terminal of the second single-ended amplifying means via the first transmission line, and connecting the first terminal of the second single-ended amplifying means to the second terminal of the first single-ended amplifying means via the second transmission line.

According to a first preferred implementation form of the second aspect of the invention, the method further comprises the step of inserting a first capacitance, especially a first capacitor, between the first terminal of the first single-ended amplifying means and the first transmission line in a serial manner or between the first transmission line and the second terminal of the second single-ended amplifying means in a serial manner.

The method further comprises the step of inserting a second capacitance, especially a second capacitor, between the first terminal of the second single-ended amplifying means and the second transmission line in a serial manner or between the second transmission line and the second terminal of the first single-ended amplifying means in a serial manner.

According to a second preferred implementation form of the second aspect of the invention, the method further comprises the step of tracking the corresponding stability factor with respect to the differential amplifier.

According to a further preferred implementation form of the second aspect of the invention, the method further comprises the step of configuring the corresponding coupling between the first terminal of the first single-ended amplifying means of the differential amplifier and the second terminal of the second single-ended amplifying means of the differential amplifier such that the corresponding stability factor with respect to the differential amplifier is constantly nearly one, preferably constantly one, more preferably constantly nearly one over a desired frequency range, most preferably constantly one over a desired frequency range, especially, in the case of tracking the corresponding stability factor, on the basis of the tracked stability factor.

In addition to this or as an alternative, the method further comprises the step of configuring the corresponding coupling between the first terminal of the second single-ended amplifying means of the differential amplifier and the second terminal of the first single-ended amplifying means of the differential amplifier such that the corresponding stability factor with respect to the differential amplifier is constantly nearly one, preferably constantly one, more preferably constantly nearly one over a desired frequency range, most preferably constantly one over a desired frequency range, especially, in the case of tracking the corresponding stability factor, on the basis of the tracked stability factor.

According to a further preferred implementation form of the second aspect of the invention, the method further comprises the step of inserting a first passive element network between the first terminal of the first single-ended amplifying means and the first transmission line in a serial manner or, in the case that the first capacitance is present, between the first terminal of the first single-ended amplifying means and the first capacitance in a serial manner.

In addition to this or as an alternative, the method further comprises the step of inserting a second passive element network between the first terminal of the second single-ended amplifying means and the second transmission line in a serial manner or, in the case that the second capacitance is present, between the first terminal of the second single-ended amplifying means and the second capacitance in a serial manner.

According to a further preferred implementation form of the second aspect of the invention, the method further comprises the step of inserting a third passive element network between the second terminal of the first single-ended amplifying means and the second transmission line in a serial manner or, in the case that a capacitance, especially the above-mentioned second capacitance, is present, between the second terminal of the first single-ended amplifying means and the second capacitance in a serial manner.

In addition to this or as an alternative, the method further comprises the step of inserting a fourth passive element network between the second terminal of the second single-ended amplifying means and the first transmission line in a serial manner or, in the case that a capacitance, especially the above-mentioned first capacitance, is present, between the second terminal of the second single-ended amplifying means and the first capacitance in a serial manner.

Exemplary embodiments of the invention are now further explained with respect to the drawings by way of example only, and not for limitation. In the drawings:
- Fig. 1: shows an exemplary embodiment of an inventive differential amplifier especially comprising capacitors in series with corresponding transmission lines;
- Fig. 2A: illustrates an abstract example of a differential Gₘₐₓ-core in the sense of the invention for further explanation of the latter;
- Fig. 2B: shows a single-ended representation regarding Fig. 2A for 2-port analysis;
- Fig. 3A: shows an exemplary plot regarding Gₘₐ versus *θ*;
- Fig. 3B: shows an exemplary plot regarding Gₘₐ versus K_{f};
- Fig. 4A: shows a further exemplary broadband Gₘₐₓ-core in the sense of the invention;
- Fig. 4B: illustrates trace fitting in the context of Fig. 4A in the sense of the invention;
- Fig. 5A: shows an exemplary plot regarding gain (versus frequency) of the implemented core of Fig. 4A;
- Fig. 5B: shows an exemplary plot regarding stability (over frequency) of the implanted core of Fig. 4A;
- Fig. 5C: shows an exemplary plot regarding *θ* (versus frequency) of the implemented core according to Fig. 4A; and
- Fig. 6: shows a flow chart of an embodiment of the second aspect of the invention.

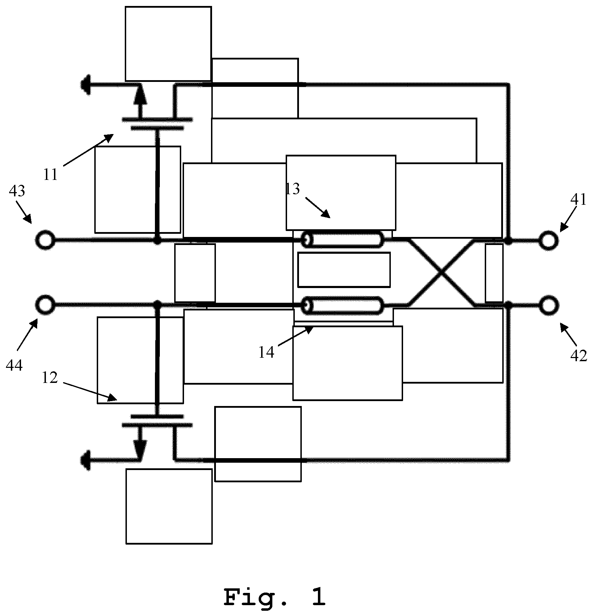

With respect to Fig. 1, a block diagram of an exemplary embodiment of an inventive differential amplifier or the core thereof, especially the Gₘₐₓ-core thereof, respectively, is shown. According to Fig. 1, said differential amplifier comprises a first transistor 11, a second transistor 12, a first transmission line 13, and a second transmission line 14.

In this context, a gate terminal of the first transistor 11 is connected to a drain terminal of the second transistor 12 via the first transmission line 13. Additionally, a gate terminal of the second transistor 12 is connected to a drain terminal of the first transistor 11 via the second transmission line 14.

The circuit diagram according to Fig. 1, especially the depicted connections thereof, can be summarized as follows: The gate terminal of the first transistor 11 is connected to a first terminal of the first transmission line 13, whereas a second terminal of said first transmission line 13 is connected to the drain terminal of the second transistor 12. By analogy therewith, the gate terminal of the second transistor 12 is connected to a first terminal of the second transmission line 14, whereas a second terminal of said second transmission line 14 is connected to the drain terminal of the first transistor 11.

Furthermore, the second terminal of the second transmission line 14 may be connected to a first tap terminal 41. Additionally or alternatively, the second terminal of the first transmission line 13 may be connected to a second tap terminal 42. It is further noted that the first terminal of the first transmission line 13 may be connected to a third tap terminal 43. The first terminal of the second transmission line 14 may be connected to a fourth tap terminal 44. Moreover, a source terminal of the first transistor 11 may preferably be connected to ground. In addition to this or as an alternative, a source terminal of the second transistor 12 may preferably be connected to ground.

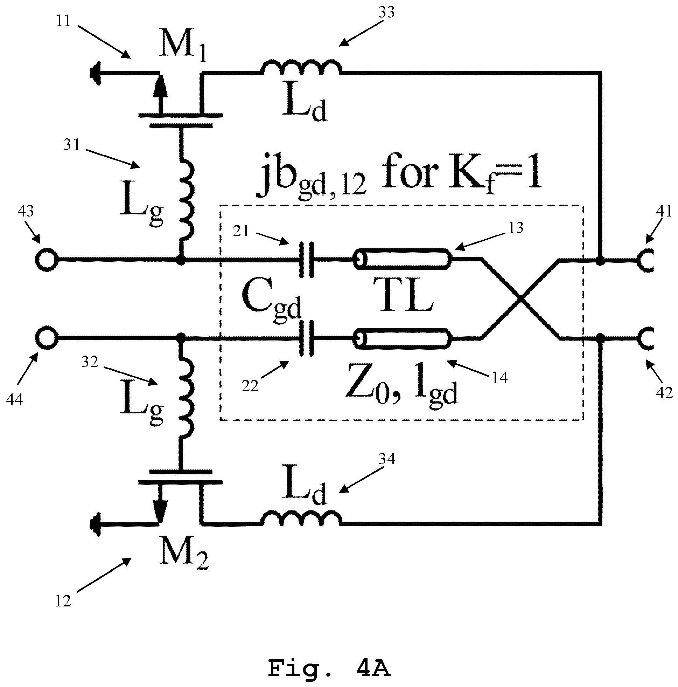

As it will be explained regarding Fig. 4A, it might be particularly advantageous if the differential amplifier further comprises a first capacitance 21, especially a first capacitor, wherein said first capacitance 21, especially said first capacitor, is inserted between the gate terminal of the first transistor 11 and the first transmission line 13 in a serial manner.

Additionally, the differential amplifier further comprises a second capacitance 22, especially a second capacitor, wherein said second capacitance 22, especially said second capacitor, is inserted between the gate terminal of the second transistor 12 and the second transmission line 14 in a serial manner.

Furthermore, it is noted that the length of the first transmission line 13 or TL, respectively may especially be between a twentieth and a tenth, preferably between a sixteenth and a fourteenth, of the respective signal wavelength. In addition to this or as an alternative, the length of the second transmission line 14 or TL, respectively, may especially be between a twentieth and a tenth, preferably between a sixteenth and a fourteenth, of the respective signal wavelength.

Moreover, it might be particularly advantageous if the length of the first transmission line 13 or TL, respectively, is at least 50 micrometers, preferably at least 100 micrometers. Additionally or alternatively, the length of the second transmission line 14 or TL, respectively, may especially be at least 50 micrometers, preferably at least 100 micrometers.

It is noted that it might be particularly advantageous if the value of the first capacitance C_{gd} is between one and three times, preferably between 1.5 and 2.5 times, the value of the respective parasitic gate capacitance of the first transistor 11 or M₁, respectively. It is further noted that it might be particularly advantageous if the value of the second capacitance C_{gd} is between one and three times, preferably between 1.5 and 2.5 times, the value of the respective parasitic gate capacitance of the second transistor 12 or M₂, respectively.

Furthermore, the value of the first capacitance C_{gd} may especially be between 50 femtofarad and 200 femtofarad, preferably between 100 femtofarad and 150 femtofarad, per millimeter of the length of the first transmission line 13 or TL, respectively. In addition to this or as an alternative, the value of the second capacitance C_{gd} may especially be between 50 femtofarad and 200 femtofarad, preferably between 100 femtofarad and 150 femtofarad, per millimeter of the length of the second transmission line 14 or TL, respectively.

Moreover, it might be particularly advantageous if the first transistor and the second transistor have the same properties. Additionally or alternative, the first transmission line and the second transmission line may especially have the same properties. In further addition to this or as further alternative, the first capacitance and the second capacitance may especially have the same properties.

It is noted that it might be particularly advantageous if at least one of the first transmission line and the second transmission line is replaced by appropriate high-order passives. Additionally or alternative, especially in the case that at least one of the first capacitance and the second capacitance is present, at least one of the corresponding series connection may preferably be replaced by appropriate high-order passives.

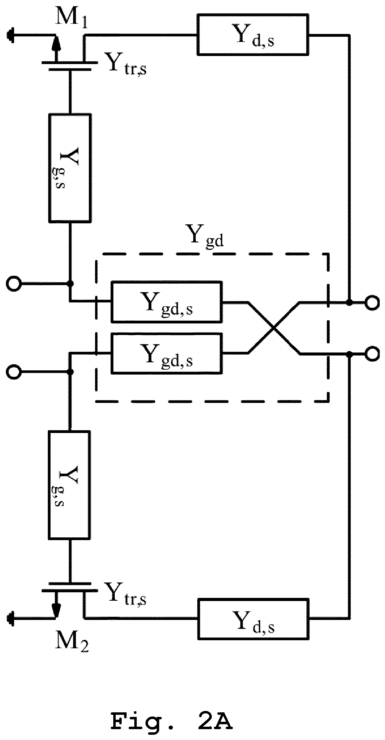

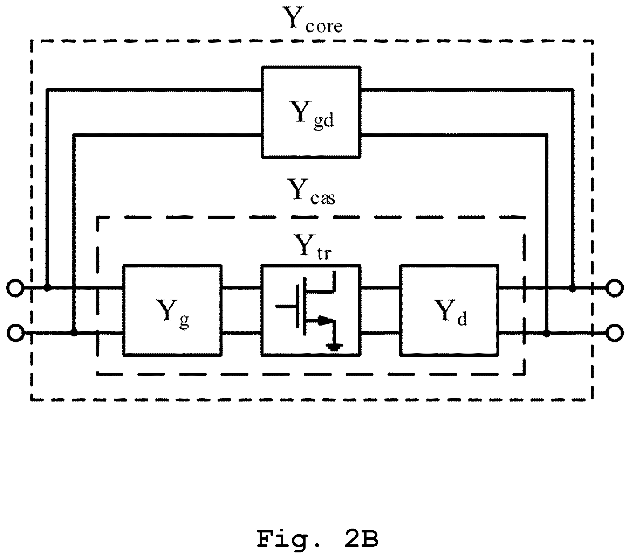

Now, with respect to Fig. 2A, an abstract example of a differential amplifier or Gₘₐₓ-core, respectively, in the sense of the invention is presented for further explanation of the invention. Before the working principle of the inventive differential Gₘₐₓ-core is investigated with the aid of Fig. 2A and Fig. 2B, it is remembered that Gₘₐₓ denotes the maximum achievable gain.

In general, the present invention comprises a broadband gain boosting technique which can achieve the Gₘₐₓ for the ultra-broad band without trading with the gain drop, thus, expand its usage in the broad band system. Furthermore, the broad band technique is especially applied on the respective differential pair, whereas the conventional structures mostly rely on the single-ended configuration.

In advance, especially in addition to the maximum achievable gain Gₘₐₓ, it is noted that two further types of gain are of interest in the following: the maximum available gain denoted as Gₘₐ, and the unilateral gain denoted as U.

With respect to Gₘₐ, it is noted that the respective input and the respective output may especially be conjugate matched. In this context, the corresponding stability factor, denoted as K_{f}, may especially be greater than one. Additionally or alternatively, with respect to U, it might be particularly advantageous if U is invariant with linear, lossless, and reciprocal passive embedding.

Again, with respect to Fig. 2A, the core is embedded by gate, drain and cross-coupled passives. The feedback path is achieved through the cross-coupled components while the gate and drain embedding provide additional design freedom as utilized in the single-ended configuration.

The differential structure can be interpreted as a 2-port network and, hereby, simplified to an equivalent single-ended configuration in Fig. 2B, wherein each Y-parameter can be translated to: $\begin{matrix}{Y}_{tr} = \frac{{Y}_{tr , s}}{2} , {Y}_{g} = \frac{{Y}_{g , s}}{2} , {Y}_{d} = \frac{{Y}_{d , s}}{2} , \\ {Y}_{gd} = \frac{1}{2} \left[\begin{matrix}{Y}_{gd , s , 11} & - {Y}_{gd , s , 12} \\ - {Y}_{gd , s , 21} & {Y}_{gd , s , 22}\end{matrix}\right]\end{matrix}$ (1)

Compared to the single-ended configuration, its Y-parameters are scaled by half and Y_{gd},₁₂ and Y_{gd},₂₁ of the cross-coupled passive change their signs due to the cross-coupling. Given the two-port parameters of the core, required conditions to achieve the Gₘₐₓ are:
1) ${K}_{f} = 1$
2) $θ = 180 ° ,$
wherein *K_{f}* denotes the above-mentioned stability factor and *θ* is a phase of a transfer parameter ratio $\frac{{Y}_{core , 21}}{{Y}_{core , 12}}$. The equivalent expression in 2-port parameters is: $- {G}_{max} = \frac{{Y}_{core , 21}}{{Y}_{core , 12}} .$ (2)

Along with the required Gₘₐₓ conditions for each embedding component, the derivation of the maximal available gain Gₘₐ with respect to *K_{f}* and *θ* indicates a direction for the broadband core design: ${G}_{ma} = \frac{1}{2} \left\{\begin{matrix}{Ua}^{2} - 2 a cos θ \left(U-1\right) + U \\ + \sqrt{{\left({Ua}^{2}-2a cos θ\left(U-1\right)+U\right)}^{2} - 4 {a}^{2}}\end{matrix}\right\} ,$ (3) wherein $a = {K}_{f} - \sqrt{{K}_{f}^{2} - 1}$ and U is the above-mentioned unilateral gain of the core.

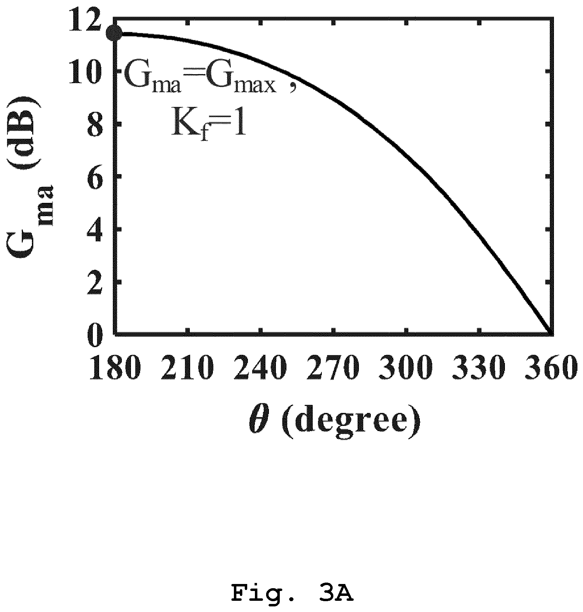

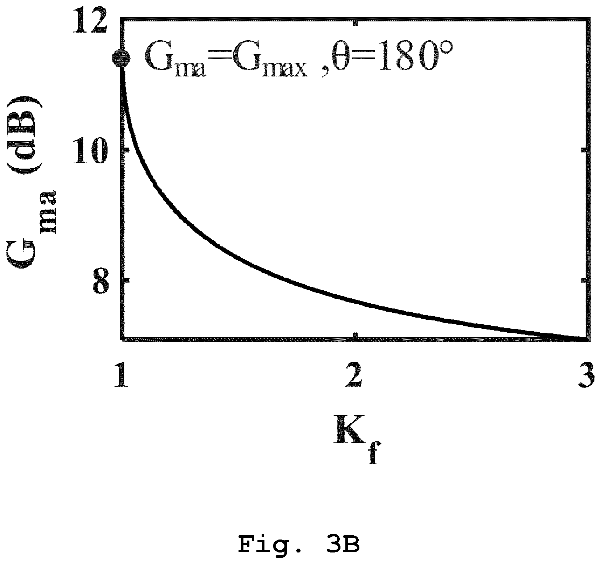

The Gₘₐ as a function of *K_{f}* and *θ* in equation (3) and Figures 3A and 3B highlight an interesting finding that the Gₘₐ varies drastically with *K_{f}* deviation around 1 rather than *θ*.

This especially explains extremely narrow gain peaks around the target frequency, where *K_{f}* varies across 1, limiting the usage of conventional Gₘₐₓ-cores to the narrow band system.

The inventive Gₘₐₓ-core thereby devises an embedding network that preferably tracks *K_{f}* = 1 condition for the frequency range of interest to avoid a Gₘₐ drop and to achieve a broadband operation.

An exemplary schematic of the inventive broadband Gₘₐₓ-core with embedding passives is shown in Fig. 4A. The core consists of gate inductors, exemplarily denoted as L_{g}, and drain inductors, exemplarily denoted as L_{d}, and cross-coupled components. In this case, the embedding passives are especially implemented in two steps.

The circuit diagram according to Fig. 4A, especially the depicted connections thereof, can be summarized as follows: As already announced regarding Fig. 1 above, the circuit of Fig. 4A basically comprises a first transistor 11, a second transistor 12, a first capacitance 21, especially a first capacitor preferably with value C_{gd}, and a second capacitance 22, especially a second capacitor preferably with value C_{gd}. In this context, it might be particularly advantageous if the first capacitance 21 and the second capacitance 22 have the same value.

Furthermore, in accordance with Fig. 4A, the circuit may comprise a first inductance 31, especially a first inductor preferably with value L_{g}, a second inductance 32, especially a second inductor preferably with value L_{g}, a third inductance 33, especially a third inductor preferably with value L_{d}, and fourth inductance 34, especially a fourth inductor preferably with value L_{d}.

In this exemplary case of Fig. 4A, a gate terminal of the first transistor 11 is connected to a first terminal of the first inductance 31, whereas a second terminal of said first inductance 31 is connected to a first terminal of the first capacitance 21. A second terminal of said first capacitance 21 is connected to a first terminal of the first transmission line 13, whereas a second terminal of said first transmission line 13 is connected to a first terminal of the fourth inductance 34. Furthermore, a second terminal of said fourth inductance 34 is connected to a drain terminal of the second transistor 12.

Moreover, a gate terminal of said second transistor 12 is connected to a first terminal of the second inductance 32, whereas a second terminal of said second inductance 32 is connected to a first terminal of the second capacitance 22. A second terminal of said second capacitance 22 is connected to a first terminal of the second transmission line 14, whereas a second terminal of said second transmission line 14 is connected to a first terminal of the third inductance 33. Furthermore, a second terminal of said third inductance 33 is connected to a drain terminal of the first transistor 11.

It is noted that the second terminal of the second transmission line 14 may be connected to a first tap terminal 41. The second terminal of the first transmission line 13 may be connected to a second tap terminal 42. Furthermore, the first terminal of the first capacitance 21 may be connected to a third tap terminal 43. The first terminal of the second capacitance 22 may be connected to a fourth tap terminal 44. Moreover, a source terminal of the first transistor 11 may preferably be connected to ground. In addition to this or as an alternative, a source terminal of the second transistor 12 may preferably be connected to ground.

It is further noted that it might be particularly advantageous if alternative embodiments of the circuit according to Fig. 4A are deduced from the embodiment depicted in Fig. 4A by shorting at least one, preferably at least two, of the inductances 31, 32, 33, 34. In this context, shorting may especially be performed in a symmetric manner, i.e. each of the first and the second inductance 31, 32, which can also be called "gate inductances", is shorted. Additionally or alternatively, each of the third and the fourth inductance 33, 34, which can also be called "drain inductances", is shorted.

First, the L_{g}, L_{d} and Y_{gd} are designed to satisfy the Gₘₐₓ conditions at the center frequency. Second, the cross-coupled passive Y_{gd} is manipulated such that the required Y-parameter values for *K_{f}* = 1 can be tracked for broad frequency range.

Furthermore, the required Y_{gd} (*bₜₐᵣ*) satisfying the *K_{f} =* 1 condition can be calculated from: ${K}_{f} = \frac{2 {g}_{eq , 11} {g}_{eq , 22} - Re \left\{{Y}_{eq , 21}{Y}_{eq , 12}\right\}}{\left|{Y}_{eq , 21}{Y}_{eq , 12}\right|} = 1 ,$ (4) wherein Yₓ=gₓ+jbₓ.

By solving the above-mentioned equation (4): $\begin{matrix}{b}_{tar} = Im \left({Y}_{gd , 12}\right) = {b}_{gd , 12} = {b}_{gd , 21} = \frac{- E \pm \sqrt{{E}^{2} - 4 DF}}{2 D} , \\ D = {{g}_{cas , 12}}^{2} + {{g}_{cas , 21}}^{2} - 4 {g}_{cas , 11} {g}_{cas , 22} + 2 {g}_{cas , 21} {g}_{cas , 12} , \\ E = 2 {{g}_{cas , 12}}^{2} {b}_{cas , 21} + 2 {{g}_{cas , 21}}^{2} {b}_{cas , 12} \\ + \left(2{g}_{cas , 21}{g}_{cas , 12}-4{g}_{cas , 11}{g}_{cas , 22}\right) \left({b}_{cas , 21}+{g}_{cas , 12}\right) , \\ F = {{g}_{cas , 12}}^{2} {{b}_{cas , 21}}^{2} + {{g}_{cas , 21}}^{2} {{b}_{cas , 12}}^{2} - 4 {{g}_{cas , 11}}^{2} {{g}_{cas , 22}}^{2} + 4 {g}_{cas , 11} {g}_{cas , 22} {g}_{cas , 21} {g}_{cas , 12} \\ - 2 {b}_{cas , 21} {b}_{cas , 12} \left(2{g}_{cas , 11}{g}_{cas , 22}-{g}_{cas , 21}{g}_{cas , 12}\right) .\end{matrix}$ (5)

In this context according to equation (5) above, it is noted that terms comprising g_{cas} and/or b_{cas} are especially defined by the above-mentioned formula Yₓ=gₓ+jbₓ. Additionally or alternatively, said definition may especially be based on the block denoted as Y_{cas} in Fig. 2B.

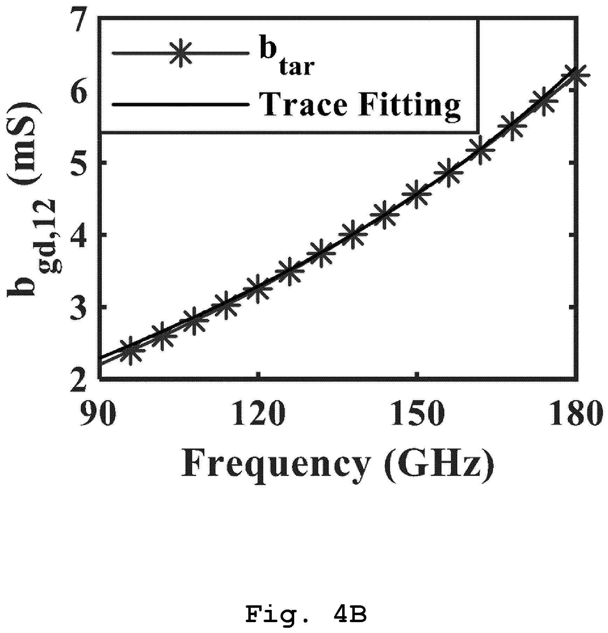

As the *bₜₐᵣ* from equation (5) in Fig. 4B exhibits positive value, the cross-coupled embedding should be capacitive and requires a series capacitor. In addition, to increase the order of freedom on the cross-coupled passive and to track the *bₜₐᵣ* across the frequency, a transmission line (TL) is connected in series with the capacitor C_{gd} as shown in Fig. 4A, which forms a Y_{gd}: $\begin{matrix}{Y}_{gd} = \\ \frac{1}{2} \left[\begin{matrix}{jωC}_{gd} + \frac{{jZ}_{0} tan \left({βl}_{gd}\right) {ω}^{2} {{C}_{gd}}^{2}}{1 - {Z}_{0} tan \left({βl}_{gd}\right) {ωC}_{gd}} & \frac{{jωC}_{gd}}{cos \left({βl}_{gd}\right) \left(1-{Z}_{0}tan\left({βl}_{gd}\right){ωC}_{gd}\right)} \\ \frac{{jωC}_{gd}}{cos \left({βl}_{gd}\right) \left(1-{Z}_{0}tan\left({βl}_{gd}\right){ωC}_{gd}\right)} & \frac{1}{{jZ}_{0} tan \left({βl}_{gd}\right)} + \frac{j}{{Z}_{0} sin \left({βl}_{gd}\right) \left(1-{Z}_{0}tan\left({βl}_{gd}\right){ωC}_{gd}\right)}\end{matrix}\right] ,\end{matrix}$ (6) wherein *Z*₀ is a characteristic impedance of the transmission line TL, *β* is a phase constant and *l_{gd}* is a length of the transmission line TL.

Moreover, especially to satisfy the Gₘₐₓ condition at the center frequency, the *C_{gd}* in equation (6) should satisfy the following equation: ${C}_{gd} = \frac{{b}_{tar , center} ⋅ cos \left({β}_{center}{l}_{gd}\right)}{2 {πf}_{0} \left(0.5+{b}_{tar , center}⋅{Z}_{0}sin\left({β}_{center}{l}_{gd}\right)\right)} ,$ (7) wherein *b_{tar,center}* and *β_{center}* stand for *bₜₐᵣ* and *β* at the center frequency f₀, respectively.

The required *Z*₀ and *l_{gd}* for the broadband operation can exemplarily be driven with the help of least squares method: ${min}_{{Z}_{0} , {l}_{gd}} {\sum }_{{f}_{l}}^{{f}_{h}} {\left({b}_{tar}-{b}_{gd , 12}\right)}^{2} ,$ (8) wherein fₗ<f₀<fₕ and fₗ and fₕ are targeted boundaries at the lowest and the highest frequency, respectively.

Furthermore, the respective trace fitting with equation (8) in Fig. 4B especially shows that the targeted *bₜₐᵣ* can be successfully approximated with appropriate passive models, preferably with the aid of the series connection of *C_{gd}* and TL, resulting in a near 1 *K_{f}* for broad frequency range.

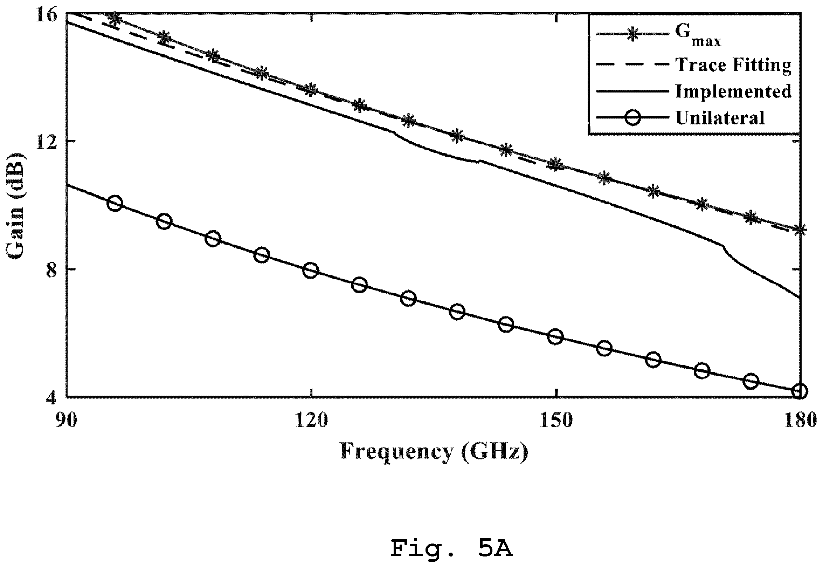

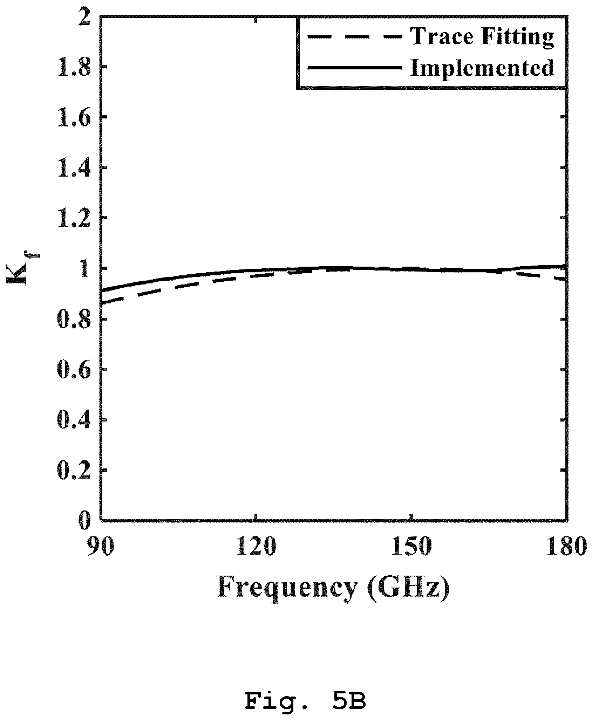

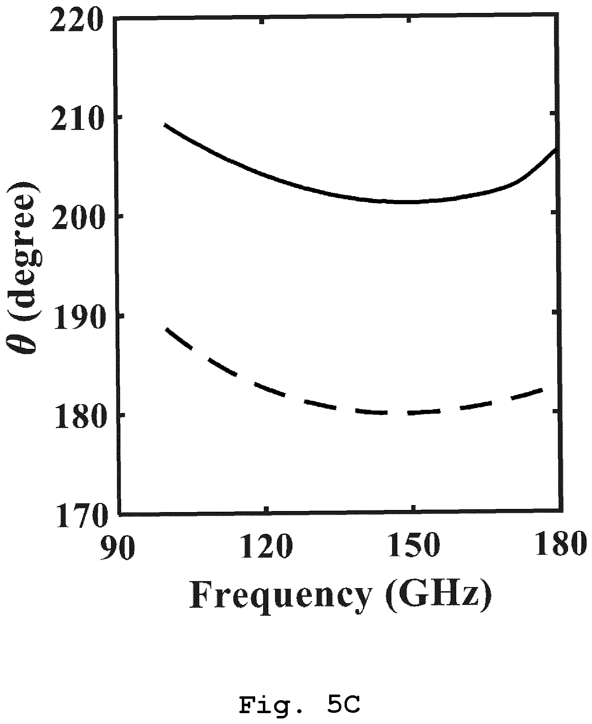

Moreover, the post-layout simulation results presented by Fig. 5A, Fig. 5B, and Fig. 5C prove that *K_{f}* = 1 condition is sustained for more than 80 GHz at 144 GHz, while its Gₘₐ tightly follows Gₘₐₓ within 1 dB deviation which is mainly due to the passive losses. The θ deviation in Fig. 5C is less than 30° which has a minor impact on the gain as described in Fig. 3A.

With respect to said Fig. 5A, it is further noted that the depicted "Gₘₐₓ"-curve can especially be understood as a theoretical target curve, whereas the "Trace Fitting"-curve can especially be interpreted as a curve with ideal lumped components. Furthermore, the "Implemented"-curve of Fig. 5A can especially be based on a layout extracted, whereas the "Unilateral"-curve can especially be seen as a curve based on unilateral gain.

Furthermore, with respect to said Fig. 5B and Fig. 5C, it is noted that these figures show the above-mentioned "Trace Fitting"-curve and "Implemented"-curve in the context of the corresponding stability factor and the above-mentioned θ deviation.

It can be summarized that the present invention allows for achieving maximum achievable gain (Gₘₐₓ) of the amplifier or transistor, respectively, for broad bandwidth. Based on the finding that a stability factor (K_{f}) deviation around 1 highly degrades a maximum available gain (Gₘₐ) and incurs gain drop around the center frequency, the inventive Gₘₐₓ-core devises embedding passives in differential configuration which can sustain the K_{f}=1 condition for broad frequency range. The inventive core especially tracks the theoretical Gₘₐₓ more than 80 GHz at 144 GHz, enabling the usage of the inventive Gₘₐₓ-core in ultra-broadband applications.

Accordingly, with the aid of the present invention, several limitations of conventional gain-boosting cores can be overcome. For example, such limitations are:
- Some conventional cores are achieved for the single frequency with extremely narrow bandwidth due to its sharp gain peaking nature.
- Some (dual-peaking) conventional cores expand the bandwidth with two gain peaks placing apart while revealing few dBs of gain drop between the gain peaks, still suffering from the gain-bandwidth trade off.
- Most conventional cores are achieved not in a differential configuration but only in a single-ended one.

For instance, especially by having overcome said limitations, the invention can be utilized in the high frequency front-end where both the high gain and broad bandwidth should be achieved such as PAs and LNAs in transceivers for communications and radars above 100 GHz.

It is noted that it might be particularly advantageous if the invention is implemented in 28nm CMOS technology.

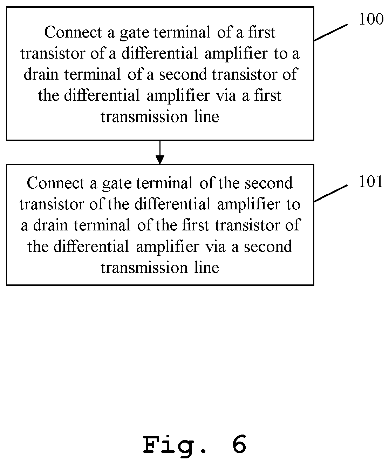

Finally, Fig. 6 shows a flow chart of an embodiment of the inventive method for achieving maximum achievable gain (Gₘₐₓ) of a differential amplifier. In a first step 100, a gate terminal of a first transistor, such as the above-mentioned transistors 11 and M₁, of the differential amplifier is connected to a drain terminal of a second transistor, such as the above-mentioned transistors 12 and M₂, of the differential amplifier via a first transmission line, such as the above-mentioned transmission lines 13 and TL.

Then, in a second step 101, a gate terminal of the second transistor of the differential amplifier is connected to a drain terminal of the first transistor of the differential amplifier via a second transmission line, such as the above-mentioned transmission lines 14 and TL.

It might be particularly advantageous if the method further comprises the step of inserting a first capacitance, such as the above-mentioned capacitance C_{gd}, especially a first capacitor, between the gate terminal of the first transistor and the first transmission line in a serial manner. In addition to this or as an alternative, the inventive method may comprise the step of inserting a second capacitance, such as C_{gd} mentioned above, especially a second capacitor, between the gate terminal of the second transistor and the second transmission line in a serial manner.

Furthermore, the length of the first transmission line may especially be between a twentieth and a tenth, preferably between a sixteenth and a fourteenth, of the corresponding signal wavelength with respect to the differential amplifier. Additionally or alternatively, the length of the second transmission line may especially be between a twentieth and a tenth, preferably between a sixteenth and a fourteenth, of the corresponding signal wavelength with respect to the differential amplifier.

It is further noted that the length of the first transmission line may especially be at least 50 micrometers, preferably at least 100 micrometers. Additionally or alternatively, the length of the second transmission line may especially be at least 50 micrometers, preferably at least 100 micrometers.

Moreover, it might be particularly advantageous if the value of the first capacitance is between one and three times, preferably between 1.5 and 2.5 times, the value of the respective parasitic gate capacitance of the first transistor of the differential amplifier.

In addition to this or as an alternative, it might be particularly advantageous if the value of the second capacitance is between one and three times, preferably between 1.5 and 2.5 times, the value of the respective parasitic gate capacitance of the second transistor of the differential amplifier.

Furthermore, the value of the first capacitance may especially be between 50 femtofarad and 200 femtofarad, preferably between 100 femtofarad and 150 femtofarad, per millimeter of the length of the first transmission line. Additionally or alternatively, the value of the second capacitance may especially be between 50 femtofarad and 200 femtofarad, preferably between 100 femtofarad and 150 femtofarad, per millimeter of the length of the second transmission line.

It is further noted that it might be particularly advantageous if the inventive method further comprises the step of tracking the corresponding stability factor (K_{f}) with respect to the differential amplifier.

Moreover, the inventive method may further comprise the step of configuring the corresponding coupling between the gate terminal of the first transistor of the differential amplifier and the drain terminal of the second transistor of the differential amplifier such that the corresponding stability factor (K_{f}) with respect to the differential amplifier is constantly nearly one, preferably constantly one, more preferably constantly nearly one over a desired frequency range, most preferably constantly one over a desired frequency range, especially, in the case of tracking the corresponding stability factor (K_{f}), on the basis of the tracked stability factor.

In addition to this or as an alternative, the inventive method may comprise the step of configuring the corresponding coupling between the gate terminal of the second transistor of the differential amplifier and the drain terminal of the first transistor of the differential amplifier such that the corresponding stability factor (K_{f}) with respect to the differential amplifier is constantly nearly one, preferably constantly one, more preferably constantly nearly one over a desired frequency range, most preferably constantly one over a desired frequency range, especially, in the case of tracking the corresponding stability factor (K_{f}), on the basis of the tracked stability factor.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defined in accordance with the following claims.

## Claims

1. A differential amplifier comprising:
a first single-ended amplifying means (11, M₁) comprising at least a first terminal and a second terminal,
a second single-ended amplifying means (12, M₂) comprising at least a first terminal and a second terminal,
a first transmission line (13, TL), and
a second transmission line (14, TL),
wherein the first terminal of the first single-ended amplifying means (11, M₁) is connected to the second terminal of the second single-ended amplifying means (12, M₂) via the first transmission line (13, TL), and
wherein the first terminal of the second single-ended amplifying means (12, M₂) is connected to the second terminal of the first single-ended amplifying means (11, M₁) via the second transmission line (14, TL),
the differential amplifier further comprises a first capacitance (21, C_{gd}), especially a first capacitor, wherein said first capacitance (21, C_{gd}), especially said first capacitor, is inserted between the first terminal of the first single-ended amplifying means (11, M₁) and the first transmission line (13, TL) in a serial manner,
the value of the first capacitance (21, C_{gd}) is between one and three times the value of the respective first-terminal-to-second-terminal capacitance of the first single-ended amplifying means (11, M₁),
the differential amplifier further comprises a second capacitance (22, C_{gd}), especially a second capacitor, wherein said second capacitance (22, C_{gd}), especially said second capacitor, is inserted between the first terminal of the second single-ended amplifying means (12, M₂) and the second transmission line (14, TL) in a serial manner,
the first single-ended amplifying means (11, M₁) comprises or is a first transistor (M₁), wherein the first terminal of the first single-ended amplifying means (11, M₁) is connected via a first inductance (31, L_{g}) or equal to a gate terminal of said first transistor (M₁) and the second terminal of the first single-ended amplifying means (11, M₁) is connected via a third inductance (33, L_{d}) or equal to a drain terminal of said first transistor (M₁), and
the second single-ended amplifying means (12, M₂) comprises or is a second transistor (M₂), wherein the first terminal of the second single-ended amplifying means (12, M₂) is connected via a second inductance (32, L_{g}) or equal to a gate terminal of said second transistor (M₂) and the second terminal of the second single-ended amplifying means (12, M₂) is connected via a fourth inductance (34, L_{d}) or equal to a drain terminal of said second transistor (M₂).

2. The differential amplifier according to claim 1,
wherein the first capacitance (21, C_{gd}) is a first capacitor, and/or
wherein the second capacitance (22, C_{gd}) is a second capacitor.

3. The differential amplifier according to claim 2,
wherein the value of the first capacitance (21, C_{gd}) is between 50 femtofarad and 200 femtofarad, preferably between 100 femtofarad and 150 femtofarad, per millimeter of the length of the first transmission line (13, TL), and/or
wherein the value of the second capacitance (22, C_{gd}) is between 50 femtofarad and 200 femtofarad, preferably between 100 femtofarad and 150 femtofarad, per millimeter of the length of the second transmission line (14, TL).

4. The differential amplifier according to any of the claims 1 to 3,
wherein the value of the first capacitance (21, C_{gd}) is between 1.5 and 2.5 times the value of the respective first-terminal-to-second-terminal capacitance of the first single-ended amplifying means (11, M₁), and/or
wherein the value of the second capacitance (22, C_{gd}) is between one and three times, preferably between 1.5 and 2.5 times, the value of the respective first-terminal-to-second-terminal capacitance of the second single-ended amplifying means (12, M₂).

5. The differential amplifier according to any of claims 1 to 4,
wherein the length of the first transmission line (13, TL) is between a twentieth and a quarter, preferably between a fifteenth and a sixth, of the respective signal wavelength, and/or
wherein the length of the second transmission line (14, TL) is between a twentieth and a quarter, preferably between a fifteenth and a sixth, of the respective signal wavelength.

6. The differential amplifier according to any of the claims 1 to 5,
wherein the length of the first transmission line (13, TL) is at least 50 micrometers, preferably at least 100 micrometers, and/or
wherein the length of the second transmission line (14, TL) is at least 50 micrometers, preferably at least 100 micrometers.

7. The differential amplifier according to any of the claims 1 to 6,
wherein the differential amplifier further comprises a first passive element network (31), wherein said first passive element network (31) is inserted between the first terminal of the first single-ended amplifying means (11, M₁) and the first transmission line (13, TL) in a serial manner or, in the case that the first capacitance (21, C_{gd}) is present, between the first terminal of the first single-ended amplifying means (11, M₁) and the first capacitance (21, C_{gd}) in a serial manner, and/or
wherein the differential amplifier further comprises a second passive element network (32), wherein said second passive element network (32) is inserted between the first terminal of the second single-ended amplifying means (12, M₂) and the second transmission line (14, TL) in a serial manner or, in the case that a second capacitance (22, C_{gd}) is present, between the first terminal of the second single-ended amplifying means (12, M₂) and the second capacitance (22, C_{gd}) in a serial manner.

8. The differential amplifier according to claim 7, wherein the first passive network (31) comprises or is the first inductance (L_{g}), especially a first inductor, and/or wherein the second passive network (32) comprises or is the second inductance (L_{g}), especially a second inductor.

9. The differential amplifier according to any of the claims 1 to 8,
wherein the differential amplifier further comprises a third passive element network (33), wherein said third passive element network (33) is inserted between the second terminal of the first single-ended amplifying means (11, M₁) and the second transmission line (14, TL) in a serial manner or, in the case that the second capacitance (22, C_{gd}) is present, between the second terminal of the first single-ended amplifying means (11, M₁) and the second capacitance (22, C_{gd}) in a serial manner, and/or
wherein the differential amplifier further comprises a fourth passive element network (34), wherein said fourth passive element network (34) is inserted between the second terminal of the second single-ended amplifying means (12, M₂) and the first transmission line (13, TL) in a serial manner or, in the case that the first capacitance (21, C_{gd}) is present, between the second terminal of the second single-ended amplifying means (12, M₂) and the first capacitance (21, C_{gd}) in a serial manner.

10. The differential amplifier according to claim 9, wherein the third passive network (33) comprises or is the third inductance (L_{d}), especially a third inductor, and/or wherein the fourth passive network (34) comprises or is the fourth inductance (L_{d}), especially a fourth inductor.

11. A method for achieving maximum achievable gain (Gₘₐₓ) of a differential amplifier, the method comprising the steps of:
providing a first single-ended amplifying means (11, M₁) comprising at least a first terminal and a second terminal, a second single-ended amplifying means (12, M₂) comprising at least a first terminal and a second terminal, a first transmission line (13, TL), and a second transmission line (14, TL),
connecting the first terminal of the first single-ended amplifying means (11, M₁) to the second terminal of the second single-ended amplifying means (12, M₂) via the first transmission line (13, TL), and
connecting the first terminal of the second single-ended amplifying means (12, M₂) to the second terminal of the first single-ended amplifying means (11, M₁) via the second transmission line (14, TL),
the method further comprising inserting a first capacitance (21, C_{gd}) between the first terminal of the first single-ended amplifying means (11, M₁) and the first transmission line (13, TL) in a serial manner,
wherein the value of the first capacitance (21, C_{gd}) is between one and three times the value of the respective first-terminal-to-second-terminal capacitance of the first single-ended amplifying means (11, M₁), and
inserting a second capacitance (22, C_{gd}), especially a second capacitor, between the first terminal of the second single-ended amplifying means (12, M₂) and the second transmission line (14, TL) in a serial manner,
wherein the first single-ended amplifying means (11, M₁) comprises or is a first transistor (M₁), wherein the first terminal of the first single-ended amplifying means (11, M₁) is connected via a first inductance (31, L_{g}) or equal to a gate terminal of said first transistor (M₁) and the second terminal of the first single-ended amplifying means (11, M₁) is connected via a third inductance (33, L_{d}) or equal to a drain terminal of said first transistor (M₁), and
wherein the second single-ended amplifying means (12, M₂) comprises or is a second transistor (M₂), wherein the first terminal of the second single-ended amplifying means (12, M₂) is connected via a second inductance (32, L_{g}) or equal to a gate terminal of said second transistor (M₂) and the second terminal of the second single-ended amplifying means (12, M₂) is connected via a fourth inductance (34, L_{d}) or equal to a drain terminal of said second transistor (M₂).

12. The method according to claim 11,
wherein the first capacitance (21, C_{gd}) is a first capacitor, and/or
wherein the second capacitance (22, C_{gd}) is a second capacitor.

13. The method according to claim 11 or 12,
wherein the method further comprises the step of:
tracking the corresponding stability factor (K_{f}) with respect to the differential amplifier.

14. The method according to any of the claims 11 to 13, wherein the method further comprises the step of:
configuring the corresponding coupling between the first terminal of the first single-ended amplifying means (11, M₁) of the differential amplifier and the second terminal of the second single-ended amplifying means (12, M₂) of the differential amplifier such that the corresponding stability factor (K_{f}) with respect to the differential amplifier is constantly nearly one, preferably constantly one, more preferably constantly nearly one over a desired frequency range, most preferably constantly one over a desired frequency range, especially, in the case of claim 13, on the basis of the tracked stability factor, and/or
configuring the corresponding coupling between the first terminal of the second single-ended amplifying means (12, M₂) of the differential amplifier and the second terminal of the first single-ended amplifying means (11, M₁) of the differential amplifier such that the corresponding stability factor (K_{f}) with respect to the differential amplifier is constantly nearly one, preferably constantly one, more preferably constantly nearly one over a desired frequency range, most preferably constantly one over a desired frequency range, especially, in the case of claim 13, on the basis of the tracked stability factor.

## Patentansprüche

1. Differenzverstärker, der Folgendes umfasst:
ein erstes Single-Ended-Verstärkungsmittel (11, M₁), das mindestens einen ersten Anschluss und einen zweiten Anschluss umfasst,
ein zweites Single-Ended-Verstärkungsmittel (12, M₂), das mindestens einen ersten Anschluss und einen zweiten Anschluss umfasst,
eine erste Übertragungsleitung (13, TL), und
eine zweite Übertragungsleitung (14, TL),
wobei der erste Anschluss des ersten Single-Ended-Verstärkungsmittels (11, M₁) über die erste Übertragungsleitung (13, TL) mit dem zweiten Anschluss des zweiten Single-Ended-Verstärkungsmittels (12, M₂) verbunden ist, und
wobei der erste Anschluss des zweiten Single-Ended-Verstärkungsmittels (12, M₂) über die zweite Übertragungsleitung (14, TL) mit dem zweiten Anschluss des ersten Single-Ended-Verstärkungsmittels (11, M₁) verbunden ist,
der Differenzverstärker ferner eine erste Kapazität (21, C_{gd}), insbesondere einen ersten Kondensator, umfasst, wobei die erste Kapazität (21, C_{gd}), insbesondere der erste Kondensator, zwischen den ersten Anschluss des ersten Single-Ended-Verstärkungsmittels (11, M₁) und die erste Übertragungsleitung (13, TL) auf serielle Weise eingefügt ist,
der Wert der ersten Kapazität (21, C_{gd}) zwischen dem Ein- und Dreifachen des Werts der jeweiligen Erster-Anschlusszu-zweiter-Anschluss-Kapazität des ersten Single-Ended-Verstärkungsmittels (11, M₁) liegt,
wobei der Differenzverstärker ferner eine zweite Kapazität (22, C_{gd}), insbesondere einen zweiten Kondensator, umfasst, wobei die zweite Kapazität (22, C_{gd}), insbesondere der zweite Kondensator, zwischen den ersten Anschluss des zweiten Single-Ended-Verstärkungsmittels (12, M₂) und die zweite Übertragungsleitung (14, TL) auf serielle Weise eingefügt ist,
das erste Single-Ended-Verstärkungsmittel (11, M₁) einen ersten Transistor (M₁) umfasst oder dieser ist, wobei der erste Anschluss des ersten Single-Ended-Verstärkungsmittels (11, M₁) über eine erste Induktivität (31, L_{g}) verbunden ist oder gleich einem Gate-Anschluss des ersten Transistors (M₁) ist, und der zweite Anschluss des ersten Single-Ended-Verstärkungsmittels (11, M₁) über eine dritte Induktivität (33, L_{d}) verbunden ist oder gleich einem Drain-Anschluss des ersten Transistors (M₁) ist, und
das zweite Single-Ended-Verstärkungsmittel (12, M₂) einen zweiten Transistor (M₂) umfasst oder dieser ist, wobei der erste Anschluss des zweiten Single-Ended-Verstärkungsmittels (12, M₂) über eine zweite Induktivität (32, L_{g}) verbunden ist oder gleich einem Gate-Anschluss des zweiten Transistors (M₂) ist, und der zweite Anschluss des zweiten Single-Ended-Verstärkungsmittels (12, M₂) über eine vierte Induktivität (34, L_{d}) verbunden ist oder gleich einem Drain-Anschluss des zweiten Transistors (M₂) ist.

2. Differenzverstärker nach Anspruch 1,
wobei die erste Kapazität (21, C_{gd}) ein erster Kondensator ist, und/oder
wobei die zweite Kapazität (22, C_{gd}) ein zweiter Kondensator ist.

3. Differenzverstärker nach Anspruch 2,
wobei der Wert der ersten Kapazität (21, C_{gd}) zwischen 50 Femtofarad und 200 Femtofarad, vorzugsweise zwischen 100 Femtofarad und 150 Femtofarad, pro Millimeter der Länge der ersten Übertragungsleitung (13, TL) liegt, und/oder wobei der Wert der zweiten Kapazität (22, C_{gd}) zwischen 50 Femtofarad und 200 Femtofarad, vorzugsweise zwischen 100 Femtofarad und 150 Femtofarad, pro Millimeter der Länge der zweiten Übertragungsleitung (14, TL) liegt.

4. Differenzverstärker nach einem der Ansprüche 1 bis 3,
wobei der Wert der ersten Kapazität (21, C_{gd}) zwischen dem 1,5- und 2,5-Fachen des Werts der jeweiligen Erster-Anschluss-zu-zweiter-Anschluss-Kapazität des ersten Single-Ended-Verstärkungsmittels (11, M₁) liegt, und/oder wobei der Wert der zweiten Kapazität (22, C_{gd}) zwischen dem Ein- und Dreifachen, vorzugsweise zwischen dem 1,5- und 2,5-Fachen, des Werts der jeweiligen Erster-Anschluss-zu-zweiter-Anschluss-Kapazität des zweiten Single-Ended-Verstärkungsmittels (12, M₂) liegt.

5. Differenzverstärker nach einem der Ansprüche 1 bis 4,
wobei die Länge der ersten Übertragungsleitung (13, TL) zwischen einem Zwanzigstel und einem Viertel, vorzugsweise zwischen einem Fünfzehntel und einem Sechstel, der jeweiligen Signalwellenlänge liegt, und/oder
wobei die Länge der zweiten Übertragungsleitung (14, TL) zwischen einem Zwanzigstel und einem Viertel, vorzugsweise zwischen einem Fünfzehntel und einem Sechstel, der jeweiligen Signalwellenlänge liegt.

6. Differenzverstärker nach einem der Ansprüche 1 bis 5,
wobei die Länge der ersten Übertragungsleitung (13, TL) mindestens 50 Mikrometer, vorzugsweise mindestens 100 Mikrometer beträgt, und/oder
wobei die Länge der zweiten Übertragungsleitung (14, TL) mindestens 50 Mikrometer, vorzugsweise mindestens 100 Mikrometer beträgt.

7. Differenzverstärker nach einem der Ansprüche 1 bis 6,
wobei der Differenzverstärker ferner ein erstes passives Elementnetzwerk (31) umfasst, wobei das erste passive Elementnetzwerk (31) zwischen den ersten Anschluss des ersten Single-Ended-Verstärkungsmittels (11, M₁) und die erste Übertragungsleitung (13, TL) auf eine serielle Weise oder, falls die erste Kapazität (21, C_{gd}) vorhanden ist, zwischen den ersten Anschluss des ersten Single-Ended-Verstärkungsmittels (11, M₁) und die erste Kapazität (21, C_{gd}) auf eine serielle Weise eingefügt ist, und/oder
wobei der Differenzverstärker ferner ein zweites passives Elementnetzwerk (32) umfasst, wobei das zweite passive Elementnetzwerk (32) zwischen den ersten Anschluss des zweiten Single-Ended-Verstärkungsmittels (12, M₂) und die zweite Übertragungsleitung (14, TL) auf eine serielle Weise oder, falls eine zweite Kapazität (22, C_{gd}) vorhanden ist, zwischen den ersten Anschluss des zweiten Single-Ended-Verstärkungsmittels (12, M₂) und die zweite Kapazität (22, C_{gd}) auf eine serielle Weise eingefügt ist.

8. Differenzverstärker nach Anspruch 7,
wobei das erste passive Netzwerk (31) die erste Induktivität (L_{g}), insbesondere ein erstes Induktivitätselement, umfasst oder ist, und/oder wobei das zweite passive Netzwerk (32) die zweite Induktivität (L_{g}), insbesondere ein zweites Induktivitätselement, umfasst oder ist.

9. Differenzverstärker nach einem der Ansprüche 1 bis 8,
wobei der Differenzverstärker ferner ein drittes passives Elementnetzwerk (33) umfasst, wobei das dritte passive Elementnetzwerk (33) zwischen den zweiten Anschluss des ersten Single-Ended-Verstärkungsmittels (11, M₁) und die zweite Übertragungsleitung (14, TL) auf eine serielle Weise oder, falls die zweite Kapazität (22, C_{gd}) vorhanden ist, zwischen den zweiten Anschluss des ersten Single-Ended-Verstärkungsmittels (11, M₁) und die zweite Kapazität (22, C_{gd}) auf eine serielle Weise eingefügt ist, und/oder
wobei der Differenzverstärker ferner ein viertes passives Elementnetzwerk (34) umfasst, wobei das vierte passive Elementnetzwerk (34) zwischen den zweiten Anschluss des zweiten Single-Ended-Verstärkungsmittels (12, M₂) und die erste Übertragungsleitung (13, TL) auf eine serielle Weise oder, falls die erste Kapazität (21, C_{gd}) vorhanden ist, zwischen den zweiten Anschluss des zweiten Single-Ended-Verstärkungsmittels (12, M₂) und die erste Kapazität (21, C_{gd}) auf eine serielle Weise eingefügt ist.

10. Differenzverstärker nach Anspruch 9,
wobei das dritte passive Netzwerk (33) die dritte Induktivität (L_{d}), insbesondere ein drittes Induktivitätselement, umfasst oder ist, und/oder wobei das vierte passive Netzwerk (34) die vierte Induktivität (L_{d}), insbesondere ein viertes Induktivitätselement, umfasst oder ist.

11. Verfahren zum Erreichen einer maximal erreichbaren Verstärkung (Gₘₐₓ) eines Differenzverstärkers, wobei das Verfahren die folgenden Schritte umfasst:
Bereitstellen eines ersten Single-Ended-Verstärkungsmittels (11, M₁), das mindestens einen ersten Anschluss und einen zweiten Anschluss umfasst, eines zweiten Single-Ended-Verstärkungsmittels (12, M₂), das mindestens einen ersten Anschluss und einen zweiten Anschluss umfasst, einer ersten Übertragungsleitung (13, TL) und einer zweiten Übertragungsleitung (14, TL),
Verbinden des ersten Anschlusses des ersten Single-Ended-Verstärkungsmittels (11, M₁) mit dem zweiten Anschluss des zweiten Single-Ended-Verstärkungsmittels (12, M₂) über die erste Übertragungsleitung (13, TL), und
Verbinden des ersten Anschlusses des zweiten Single-Ended-Verstärkungsmittels (12, M₂) mit dem zweiten Anschluss des ersten Single-Ended-Verstärkungsmittels (11, M₁) über die zweite Übertragungsleitung (14, TL),
wobei das Verfahren ferner Einfügen einer ersten Kapazität (21, C_{gd}) zwischen den ersten Anschluss des ersten Single-Ended-Verstärkungsmittels (11, M₁) und die erste Übertragungsleitung (13, TL) auf serielle Weise umfasst,
wobei der Wert der ersten Kapazität (21, C_{gd}) zwischen dem Ein- und Dreifachen des Werts der jeweiligen Erster-Anschluss-zu-zweiter-Anschluss-Kapazität des ersten Single-Ended-Verstärkungsmittels (11, M₁) liegt, und
Einfügen einer zweiten Kapazität (22, C_{gd}), insbesondere eines zweiten Kondensators, zwischen den ersten Anschluss des zweiten Single-Ended-Verstärkungsmittels (12, M₂) und die zweite Übertragungsleitung (14, TL) auf serielle Weise,
wobei das erste Single-Ended-Verstärkungsmittel (11, M₁) einen ersten Transistor (M₁) umfasst oder dieser ist, wobei der erste Anschluss des ersten Single-Ended-Verstärkungsmittels (11, M₁) über eine erste Induktivität (31, L_{g}) verbunden ist oder gleich einem Gate-Anschluss des ersten Transistors (M₁) ist, und der zweite Anschluss des ersten Single-Ended-Verstärkungsmittels (11, M₁) über eine dritte Induktivität (33, L_{d}) verbunden ist oder gleich einem Drain-Anschluss des ersten Transistors (M₁) ist, und
wobei das zweite Single-Ended-Verstärkungsmittel (12, M₂) einen zweiten Transistor (M₂) umfasst oder dieser ist, wobei der erste Anschluss des zweiten Single-Ended-Verstärkungsmittels (12, M₂) über eine zweite Induktivität (32, L_{g}) verbunden ist oder gleich einem Gate-Anschluss des zweiten Transistors (M₂) ist, und der zweite Anschluss des zweiten Single-Ended-Verstärkungsmittels (12, M₂) über eine vierte Induktivität (34, L_{d}) verbunden ist oder gleich einem Drain-Anschluss des zweiten Transistors (M₂) ist.

12. Verfahren nach Anspruch 11,
wobei die erste Kapazität (21, C_{gd}) ein erster Kondensator ist, und/oder
wobei die zweite Kapazität (22, C_{gd}) ein zweiter Kondensator ist.

13. Verfahren nach Anspruch 11 oder 12,
wobei das Verfahren ferner den folgenden Schritt umfasst: Verfolgen des entsprechenden Stabilitätsfaktors (K_{f}) bezüglich des Differenzverstärkers.

14. Verfahren nach einem der Ansprüche 11 bis 13,
wobei das Verfahren ferner den folgenden Schritt umfasst: Konfigurieren der entsprechenden Kopplung zwischen dem ersten Anschluss des ersten Single-Ended-Verstärkungsmittels (11, M₁) des Differenzverstärkers und dem zweiten Anschluss des zweiten Single-Ended-Verstärkungsmittels (12, M₂) des Differenzverstärkers, so dass der entsprechende Stabilitätsfaktor (K_{f}) bezüglich des Differenzverstärkers konstant nahezu eins, vorzugsweise konstant eins, besonders bevorzugt konstant nahezu eins über einen gewünschten Frequenzbereich, am meisten bevorzugt konstant eins über einen gewünschten Frequenzbereich, insbesondere im Fall des Anspruchs 13, auf der Basis des verfolgten Stabilitätsfaktors ist, und/oder
Konfigurieren der entsprechenden Kopplung zwischen dem ersten Anschluss des zweiten Single-Ended-Verstärkungsmittels (12, M₂) des Differenzverstärkers und dem zweiten Anschluss des ersten Single-Ended-Verstärkungsmittels (11, M₁) des Differenzverstärkers, so dass der entsprechende Stabilitätsfaktor (K_{f}) bezüglich des Differenzverstärkers konstant nahezu eins, vorzugsweise konstant eins, besonders bevorzugt konstant nahezu eins über einen gewünschten Frequenzbereich, am meisten bevorzugt konstant eins über einen gewünschten Frequenzbereich, insbesondere im Fall des Anspruchs 13, auf der Basis des verfolgten Stabilitätsfaktors ist.

## Revendications

1. Amplificateur différentiel comprenant :
un premier moyen d'amplification asymétrique (11, M₁) comprenant au moins une première borne et une deuxième borne,
un deuxième moyen d'amplification asymétrique (12, M₂) comprenant au moins une première borne et une deuxième borne,
une première ligne de transmission (13, TL), et
une deuxième ligne de transmission (14, TL),
la première borne du premier moyen d'amplification asymétrique (11, M₁) étant connectée à la deuxième borne du deuxième moyen d'amplification asymétrique (12, M₂) par l'intermédiaire de la première ligne de transmission (13, TL), et
la première borne du deuxième moyen d'amplification asymétrique (12, M₂) étant connectée à la deuxième borne du premier moyen d'amplification asymétrique (11, M₁) par l'intermédiaire de la deuxième ligne de transmission (14, TL),
l'amplificateur différentiel comprenant en outre une première capacité (21, C_{gd}), en particulier un premier condensateur, ladite première capacité (21, C_{gd}), en particulier ledit premier condensateur, étant intercalée en série entre la première borne du premier moyen d'amplification asymétrique (11, M₁) et la première ligne de transmission (13, TL),
la valeur de la première capacité (21, C_{gd}) étant comprise entre une et trois fois la valeur de la capacité respective entre la première borne et la deuxième borne du premier moyen d'amplification asymétrique (11, M₁),
l'amplificateur différentiel comprenant en outre une deuxième capacité (22, C_{gd}), en particulier un deuxième condensateur, ladite deuxième capacité (22, C_{gd}), en particulier ledit deuxième condensateur, étant intercalée en série entre la première borne du deuxième moyen d'amplification asymétrique (12, M₂) et la deuxième ligne de transmission (14, TL),
le premier moyen d'amplification asymétrique (11, M₁) comprenant ou étant un premier transistor (M₁), la première borne du premier moyen d'amplification asymétrique (11, M₁) étant connectée, par l'intermédiaire d'une première inductance (31, L_{g}), à une borne de grille dudit premier transistor (M₁) ou constituant celle-ci, et la deuxième borne du premier moyen d'amplification asymétrique (11, M₁) étant connectée, par l'intermédiaire d'une troisième inductance (33, L_{d}), à une borne de drain dudit premier transistor (M₁) ou constituant celle-ci, et le deuxième moyen d'amplification asymétrique (12, M₂) comprenant ou étant un deuxième transistor (M₂), la première borne du deuxième moyen d'amplification asymétrique (12, M₂) étant connectée, par l'intermédiaire d'une deuxième inductance (32, L_{g}), à une borne de grille dudit deuxième transistor (M₂) ou constituant celle-ci, et la deuxième borne du deuxième moyen d'amplification asymétrique (12, M₂) étant connectée, par l'intermédiaire d'une quatrième inductance (34, L_{d}), à une borne de drain dudit deuxième transistor (M₂) ou constituant celle-ci.

2. Amplificateur différentiel selon la revendication 1,
dans lequel la première capacité (21, C_{gd}) est un premier condensateur, et/ou
dans lequel la deuxième capacité (22, C_{gd}) est un deuxième condensateur.

3. Amplificateur différentiel selon la revendication 2,
dans lequel la valeur de la première capacité (21, C_{gd}) est comprise entre 50 femtofarads et 200 femtofarads, de préférence entre 100 femtofarads et 150 femtofarads, par millimètre de la longueur de la première ligne de transmission (13, TL), et/ou
dans lequel la valeur de la deuxième capacité (22, C_{gd}) est comprise entre 50 femtofarads et 200 femtofarads, de préférence entre 100 femtofarads et 150 femtofarads, par millimètre de la longueur de la deuxième ligne de transmission (14, TL).

4. Amplificateur différentiel selon l'une quelconque des revendications 1 à 3,
dans lequel la valeur de la première capacité (21, C_{gd}) est comprise entre 1,5 et 2,5 fois la valeur de la capacité respective entre la première borne et la deuxième borne du premier moyen d'amplification asymétrique (11, M₁), et/ou
dans lequel la valeur de la deuxième capacité (22, C_{gd}) est comprise entre une et trois fois, de préférence entre 1,5 et 2,5 fois, la valeur de la capacité respective entre la première borne et la deuxième borne du deuxième moyen d'amplification asymétrique (12, M₂).

5. Amplificateur différentiel selon l'une quelconque des revendications 1 à 4,
dans lequel la longueur de la première ligne de transmission (13, TL) est comprise entre un vingtième et un quart, de préférence entre un quinzième et un sixième, de la longueur d'onde de signal respective, et/ou
dans lequel la longueur de la deuxième ligne de transmission (14, TL) est comprise entre un vingtième et un quart, de préférence entre un quinzième et un sixième, de la longueur d'onde de signal respective.

6. Amplificateur différentiel selon l'une quelconque des revendications 1 à 5,
dans lequel la longueur de la première ligne de transmission (13, TL) est d'au moins 50 micromètres, de préférence d'au moins 100 micromètres, et/ou
dans lequel la longueur de la deuxième ligne de transmission (14, TL) est d'au moins 50 micromètres, de préférence d'au moins 100 micromètres.

7. Amplificateur différentiel selon l'une quelconque des revendications 1 à 6,
l'amplificateur différentiel comprenant en outre un premier réseau d'éléments passifs (31), ledit premier réseau d'éléments passifs (31) étant intercalé en série entre la première borne du premier moyen d'amplification asymétrique (11, M₁) et la première ligne de transmission (13, TL) ou, dans le cas où la première capacité (21, C_{gd}) est présente, en série entre la première borne du premier moyen d'amplification asymétrique (11, M₁) et la première capacité (21, C_{gd}), et/ou
l'amplificateur différentiel comprenant en outre un deuxième réseau d'éléments passifs (32), ledit deuxième réseau d'éléments passifs (32) étant intercalé en série entre la première borne du deuxième moyen d'amplification asymétrique (12, M₂) et la deuxième ligne de transmission (14, TL) ou, dans le cas où une deuxième capacité (22, C_{gd}) est présente, en série entre la première borne du deuxième moyen d'amplification asymétrique (12, M₂) et la deuxième capacité (22, C_{gd}).

8. Amplificateur différentiel selon la revendication 7,
dans lequel le premier réseau passif (31) comprend ou est la première inductance (L_{g}), en particulier une première bobine d'inductance, et/ou dans lequel le deuxième réseau passif (32) comprend ou est la deuxième inductance (L_{g}), en particulier une deuxième bobine d'inductance.

9. Amplificateur différentiel selon l'une quelconque des revendications 1 à 8,
l'amplificateur différentiel comprenant en outre un troisième réseau d'éléments passifs (33), ledit troisième réseau d'éléments passifs (33) étant intercalé en série entre la deuxième borne du premier moyen d'amplification asymétrique (11, M₁) et la deuxième ligne de transmission (14, TL) ou, dans le cas où la deuxième capacité (22, C_{gd}) est présente, en série entre la deuxième borne du premier moyen d'amplification asymétrique (11, M₁) et la deuxième capacité (22, C_{gd}), et/ou
l'amplificateur différentiel comprenant en outre un quatrième réseau d'éléments passifs (34), ledit quatrième réseau d'éléments passifs (34) étant intercalé en série entre la deuxième borne du deuxième moyen d'amplification asymétrique (12, M₂) et la première ligne de transmission (13, TL) ou, dans le cas où la première capacité (21, C_{gd}) est présente, en série entre la deuxième borne du deuxième moyen d'amplification asymétrique (12, M₂) et la première capacité (21, C_{gd}).

10. Amplificateur différentiel selon la revendication 9,
dans lequel le troisième réseau passif (33) comprend ou est la troisième inductance (L_{d}), en particulier une troisième bobine d'inductance, et/ou dans lequel le quatrième réseau passif (34) comprend ou est la quatrième inductance (L_{d}), en particulier une quatrième bobine d'inductance.

11. Procédé d'obtention d'un gain maximal réalisable (Gₘₐₓ) d'un amplificateur différentiel, le procédé comprenant les étapes suivantes :
la fourniture d'un premier moyen d'amplification asymétrique (11, M₁) comprenant au moins une première borne et une deuxième borne, d'un deuxième moyen d'amplification asymétrique (12, M₂) comprenant au moins une première borne et une deuxième borne, d'une première ligne de transmission (13, TL) et d'une deuxième ligne de transmission (14, TL),
la connexion de la première borne du premier moyen d'amplification asymétrique (11, M₁) à la deuxième borne du deuxième moyen d'amplification asymétrique (12, M₂) par l'intermédiaire de la première ligne de transmission (13, TL), et
la connexion de la première borne du deuxième moyen d'amplification asymétrique (12, M₂) à la deuxième borne du premier moyen d'amplification asymétrique (11, M₁) par l'intermédiaire de la deuxième ligne de transmission (14, TL),
le procédé comprenant en outre l'intercalage d'une première capacité (21, C_{gd}) en série entre la première borne du premier moyen d'amplification asymétrique (11, M₁) et la première ligne de transmission (13, TL),
la valeur de la première capacité (21, C_{gd}) étant comprise entre une et trois fois la valeur de la capacité respective entre la première borne et la deuxième borne du premier moyen d'amplification asymétrique (11, M₁), et l'intercalage d'une deuxième capacité (22, C_{gd}), en particulier un deuxième condensateur, en série entre la première borne du deuxième moyen d'amplification asymétrique (12, M₂) et la deuxième ligne de transmission (14, TL),
le premier moyen d'amplification asymétrique (11, M₁) comprenant ou étant un premier transistor (M₁), la première borne du premier moyen d'amplification asymétrique (11, M₁) étant connectée, par l'intermédiaire d'une première inductance (31, L_{g}), à une borne de grille dudit premier transistor (M₁) ou constituant celle-ci, et la deuxième borne du premier moyen d'amplification asymétrique (11, M₁) étant connectée, par l'intermédiaire d'une troisième inductance (33, L_{d}), à une borne de drain dudit premier transistor (M₁) ou constituant celle-ci, et le deuxième moyen d'amplification asymétrique (12, M₂) comprenant ou étant un deuxième transistor (M₂), la première borne du deuxième moyen d'amplification asymétrique (12, M₂) étant connectée, par l'intermédiaire d'une deuxième inductance (32, L_{g}), à une borne de grille dudit deuxième transistor (M₂) ou constituant celle-ci, et la deuxième borne du deuxième moyen d'amplification asymétrique (12, M₂) étant connectée, par l'intermédiaire d'une quatrième inductance (34, L_{d}), à une borne de drain dudit deuxième transistor (M₂) ou constituant celle-ci.

12. Procédé selon la revendication 11,
dans lequel la première capacité (21, C_{gd}) est un premier condensateur, et/ou
dans lequel la deuxième capacité (22, C_{gd}) est un deuxième condensateur.

13. Procédé selon la revendication 11 ou 12,
le procédé comprenant en outre l'étape suivante :
le suivi du facteur de stabilité (K_{f}) correspondant par rapport à l'amplificateur différentiel.

14. Procédé selon l'une quelconque des revendications 11 à 13,
le procédé comprenant en outre l'étape suivante :
la configuration du couplage correspondant entre la première borne du premier moyen d'amplification asymétrique (11, M₁) de l'amplificateur différentiel et la deuxième borne du deuxième moyen d'amplification asymétrique (12, M₂) de l'amplificateur différentiel de sorte que le facteur de stabilité (K_{f}) correspondant par rapport à l'amplificateur différentiel soit constamment proche de un, de préférence constamment égal à un, de préférence encore constamment proche de un sur une plage de fréquences souhaitée, idéalement constamment égal à un sur une plage de fréquences souhaitée, en particulier, dans le cas de la revendication 13, sur la base du facteur de stabilité suivi, et/ou
la configuration du couplage correspondant entre la première borne du deuxième moyen d'amplification asymétrique (12, M₂) de l'amplificateur différentiel et la deuxième borne du premier moyen d'amplification asymétrique (11, M₁) de l'amplificateur différentiel de sorte que le facteur de stabilité (K_{f}) correspondant par rapport à l'amplificateur différentiel soit constamment proche de un, de préférence constamment égal à un, de préférence encore constamment proche de un sur une plage de fréquences souhaitée, idéalement constamment égal à un sur une plage de fréquences souhaitée, en particulier, dans le cas de la revendication 13, sur la base du facteur de stabilité suivi.
